# EUROPEAN PATENT SPECIFICATION

(11) **EP 1 943 670 B1**
(45) Date of publication and mention of the grant of the patent: **19.12.2012**
(21) Application number: 06809507.4
(22) Date of filing: 05.10.2006
(51) Int. Cl.: H01L 21/336, H01L 21/762, H01L 21/20

(54) **Semiconductor device**
Halbleiterbauelement
Dispositif semi-conducteur

(30) Priority: 06.10.2005 EP 05109284
(43) Date of publication of application: 16.07.2008
(73) Proprietor: NXP B.V., 5656 AG Eindhoven (NL); Philips Intellectual Property & Standards GmbH, 20099 Hamburg (DE)
(72) Inventor: EUEN, Wolfgang, Redhill Surrey RH1 5HA (GB); SCHLIGTENHORST, Holger, Redhill Surrey RH1 5HA (GB); BAUER, Rainer, Redhill Surrey RH1 5HA (GB); VAN GEFFEN, Marc, Redhill Surrey RH1 5HA (GB); KRAFT, Karl-Heinz, Redhill Surrey RH1 5HA (GB)
(74) Representative: Williamson, Paul Lewis
(86) International application number: PCT/IB2006/053642
(87) International publication number: WO 2007/039881

(56) References cited:
- EP-A- 0 971 395
- JP-A- 11 191 617
- US-A1- 2003 205 191
- US-A1- 2005 014 346
- US-B1- 6 909 146

## Description

The invention relates to a method of manufacturing a semiconductor device with a substrate and a semiconductor body comprising silicon which is provided with at least one semiconductor element, wherein an epitaxial semiconductor layer comprising silicon is grown on top of a first semiconductor substrate, wherein a splitting region is formed in the epitaxial layer, wherein a second substrate is attached by wafer bonding to the first substrate at the side of the epitaxial layer provided with the splitting region while an electrically insulating region is interposed between the epitaxial layer and the second substrate, the structure thus formed is split at the location of the splitting region as a result of which the second substrate forms the substrate with on top of the insulating region a part of the epitaxial layer forming the semiconductor body in which the semiconductor element is formed.

The invention also relates to a semiconductor device obtained with such a - method and to manufacturing method for a semiconductor body suitable for use in such a method and to a semiconductor body obtained with such a method.

Such a method is very suitable for making semiconductor devices like ICs (= Integrated Circuit). However, other devices such as discrete devices are obtainable as well by such a method.

A method as mentioned in the opening paragraph is known from JP-11-191617 that has been published on 13-07-1999. In this document a method of manufacturing devices in a so-called SOI (= Semiconductor On Insulator) wafer structure is described. In a first embodiment a method is proposed in which an epitaxial layer of silicon with a thickness in the range of 0,5 to 2,5 µm is provided on a first silicon substrate. Subsequently an insulating region in the form of an oxide layer is formed on top of the epitaxial layer by thermal oxidation. Next a splitting region is formed in the epitaxial layer by implanting hydrogen ions through and below the oxide layer into the epitaxial layer. Next a second substrate of silicon is wafer bonded to the oxide layer on top of the epitaxial layer on the first substrate. After a splitting process in which the structure is ruptured at the splitting region the second substrate forms the substrate of the semiconductor device to be manufactured with on top of the insulating region a part of the epitaxial layer that forms a semiconductor body comprising silicon in which one or more semiconductor elements can be formed.

A drawback of such a method is that its yield of suitable semiconductor devices is rather low in case of semiconductor devices containing certain semiconductor elements, e.g. FETs and in particular high voltage FETs (= Field Effect Transistors).

It is therefore an object of the present invention to avoid the above drawbacks and to provide a method, which results in devices, in particular those that contain high voltage FETs with a high yield.

The invention is defined in the accompanying claims.

The invention is based on the surprising recognition that the yield of the manufacturing of in particular high voltage FETs is limited by the fact that the gate oxide of these FETs on top of the part of the epitaxial layer has a varying thickness in lateral directions which e.g. causes local differences in electric field and charge capacitance behavior for transistors. These differences result in e.g. differences in leakage current or breakdown characteristics through which the yield is reduced.

The invention further is based on the recognition that such a varying thickness of the gate oxide is caused by facets of certain pyramid shaped defects that cause a local different oxidation rate of the surface of the epitaxial layer. The thickness differences of the gate oxide, normally a thermal oxide, decrease or even vanish if the temperature at which the gate oxide is formed, is increased. However, such increased temperature intervenes with requirements of a low thermal budget in advanced processes. Finally, the invention is based on the recognition that such defects can be removed by increasing the thickness of the epitaxial layer to a value between 5 and 15 µm.

Best results were obtained with a thickness value between 7 and 13 µm. Although higher thickness values are suitable as well, they increase the process time and are therefore to be avoided. This is quite surprisingly since the defects in question vary in size from 0,3 to 1,3 µm and one thus would expect that the influence of such defects would be vanished already at the usual thickness for the epitaxial layer.

With a method according to the invention semiconductor devices with high voltage, i.e. having operating voltages between 20 Volt and e.g. 150 Volt, FETs are obtainable with a high yield.

Preferably the splitting region is formed by a hydrogen implant at a distance from the surface of the epitaxial layer that lies between 0,05 and 2,0 micrometer. This implies that the semiconductor body comprising silicon has about the same thickness.

In an important embodiment of a method according to the invention, in which for the second substrate a semiconductor substrate is chosen and in which the electrically insulating region is formed by an electrically insulating layer, the electrically insulating layer is deposited or grown on the second substrate before the wafer bonding. It has been found that in this way the yield of the manufacturing process is further improved. This can be explained by the fact that position of the splitting region can be formed in a more homogeneous and accurate manner since the implantation is not done through the insulating region because in this preferred embodiment said region is present on the other (second) substrate.

The semiconductor element, in particular the high voltage FET is formed in the part of the epitaxial layer remaining on top of the insulating layer which in turn is on top of the second substrate, e.g. by forming a thermal oxide on top of the silicon and forming a gate region on top thereof while source and drain regions are formed in the surface of the semiconductor body by suitable ion implantations that border - viewed in projection - the gate region.

The invention further comprises a semiconductor device obtained with a method according to the invention.

In this way a semiconductor body with a so-called SOI (= Semiconductor On Insulator) structure is obtained that can be used to form semiconductor devices like those that contain high-voltage FETs.

The semiconductor body obtained in this way forms in itself an attractive product since the device manufacture and the manufacture of the semiconductor body do not need to take place at one location or by one single manufacturer.

These and other aspects of the invention will be apparent from and elucidated with reference to the embodiments described hereinafter, to be read in conjunction with the drawing, in which

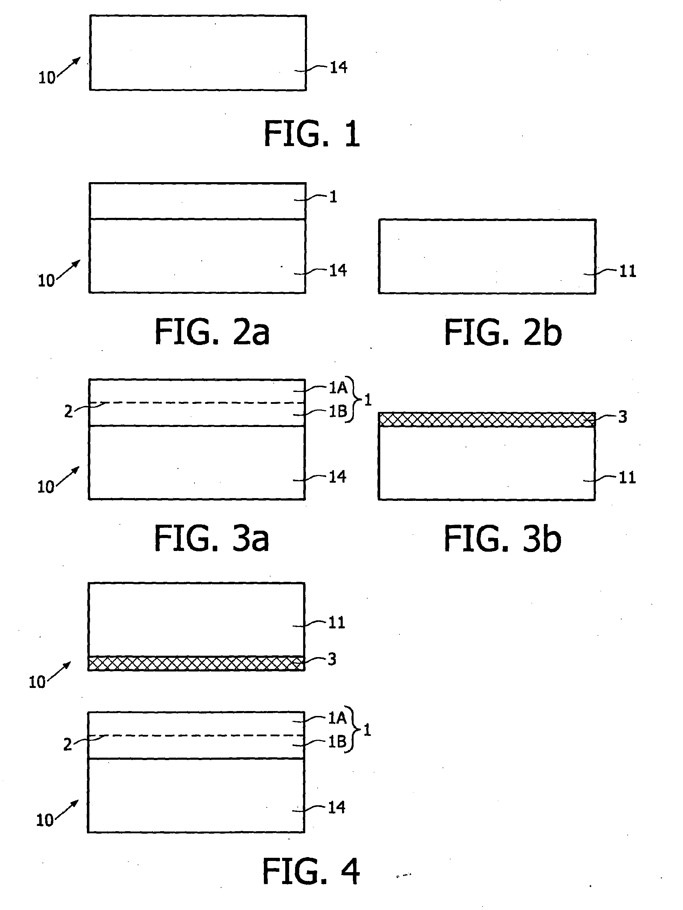

Figs. 1 through 7 are sectional views of a semiconductor device at various stages in its manufacture by means of a method in accordance with the invention.

The Figures are diagrammatic and not drawn to scale, the dimensions in the thickness direction being particularly exaggerated for greater clarity. Corresponding parts are generally given the same reference numerals and the same hatching in the various Figures.

Figs 1 through 7 are sectional views of a semiconductor device at various stages in its manufacture by-means of a method in accordance with the invention.

The semiconductor device manufactured in this example is a high voltage field effect transistor.

In a first step of the manufacture of device 10 (see Fig. 1) a first substrate 14, here of silicon, is provided with (see Fig. 2a) an epitaxial layer 1 comprising silicon, here of pure silicon, with a thickness of 12 µm. The deposition takes place at a pressure of 0.15 to 1 atm and a temperature of 1000 to 1200 °C. The epi layer 1 is here p-type doped with a doping concentration of about 10¹⁵ at/cm³ (specific resistance of about 13 Ωcm). Furthermore (see Fig. 2b) a second substrate 11 is prepared, here also of silicon and with a standard thickness. Both substrates 11,14 are here of the p-type conductivity and have a doping concentration ranging from that of intrinsic material to e.g. about 10¹⁵ at/cm³.

Next (see Fig. 3a) a splitting region 2 is formed in the silicon epitaxial layer 1 on the first substrate 14. This is done by performing an implantation of hydrogen in the epi layer 1. In this way said layer is "split" in two parts 1A,1B, the former having a thickness of 0.05 to 2.0 µm, in this example 1.5 µm, while the latter comprises about the remainder of the thickness of the epi layer 1. The implantation energy varies between 10 and 400 keV and is in this example 200 keV while the dose varies between 10¹⁶ and 10¹⁷ at/cm² and in this example is about 5 x 10¹⁶ at/cm²_{.} Furthermore (see Fig. 3b) the second substrate 11 is provided with an electrically insulating layer 3, here in de form of a thermal silicon dioxide layer 3 which is provided by exposure to an oxygen containing ambient at a temperature of about 1050 °C. The oxide layer 3 obtained has a thickness of 0.1 to 1 µm and is in this example 1 µm thick.

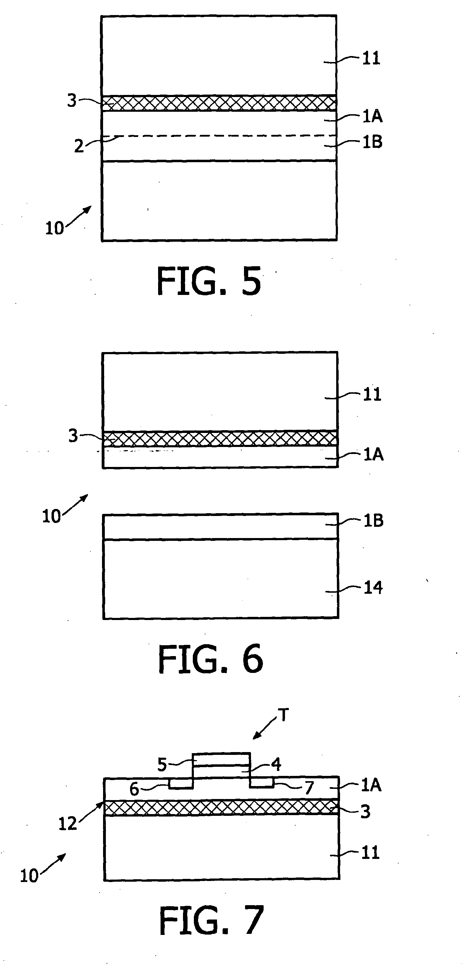

Subsequently (see Fig. 4), the second substrate 11 provided with the electrically insulating layer 3 is wafer bonded to the first substrate 14 at its side that is provided with the epitaxial layer 1 which in turn is already at this stage provided with the splitting region 2. The resulting structure is shown in Fig. 5.

Now (see Fig. 6) the structure of Fig. 5 is subjected to a splitting treatment, which comprises heating of the structure to a temperature in the range of 500 to 600 °C, in this example at 500 °C in a furnace and under an atmosphere of N₂ at a pressure of 1 atm. By this treatment the structure of Fig. 5 is split into two parts on both sides of the splitting region 2, the upper part forming the device 10 to be manufactured at this stage and in the drawing shown upside down.

Next (see Fig. 7) the device 10 is shown upside up and with a transistor T being formed in the epitaxial layer 1A above the insulating layer 3. The transistor T has gate oxide 4, here a thermal oxide of 30 nm on top of which a gate region 5, e.g. of polycrystalline silicon is formed. Aligned with the gate region 5 n-type source and drain regions 6,7 are formed in the silicon of the epilayer part 1A. The MOS (= Metal Oxide Semiconductor) FET transistor T is designed and sized in this example in such a way that its operating voltage is in the range of 20 to 120 Volt. Both gate region 5 and source and drain regions 6,7 are provided with suitable connection regions that however are not shown in the drawing.

Individual devices 10 that are suitable for mounting are obtained after applying a separation technique like etching or sawing. Thanks to the method according to the invention the high-voltage MOSFET device 10 is obtained with a high yield and uniform properties.

It will be obvious that the invention is not limited to the examples described herein, and that within the scope of the invention many variations and modifications are possible to those skilled in the art.

For example it is to be noted although described for the manufacture of a discrete MOSFET device, the present invention is particularly suitable for the manufacture of (high-voltage) ICs like (C)MOS or BI(C)MOS ICs but also for bipolar ICs.

Furthermore it is noted that various modifications are possible with respect to individual steps. For example instead of a VPE (= Vapor Phase Epitaxy) other epitaxial growth techniques like MBE (= Molecular Beam Epitaxy) or ALE (Atomic Layer Epitaxy) can be used. For the insulating layer other deposition techniques may be used like CVD (= Chemical Vapor Deposition) and it may be made of other dielectric materials like silicon nitride. The epitaxial layer comprising silicon may comprise other materials like a mixed crystal of silicon and germanium.

The splitting region may also be formed in another way, like by implanting helium ions in stead of hydrogen ions into the epitaxial layer.

Finally it is to be noted that where in the example a step is mentioned to take place at the same time, this is not at all a necessary limitation but merely is an example.

## Claims

1. Method of manufacturing a semiconductor body (12) comprising silicon and a substrate (11) wherein an epitaxial semiconductor layer (1) comprising silicon is formed on top of a first semiconductor substrate (14), wherein a splitting region (2) is formed in the epitaxial layer (1), wherein a second substrate (11) is attached by wafer bonding to the first substrate (14) at the side of the epitaxial layer (1) provided with the splitting region (2) while an electrically insulating region (3) is interposed between the epitaxial layer (1) and the second substrate (11), the structure thus formed is split at the location of the splitting region (2) as a result of which the second substrate (11) forms the substrate (11) with on top of the insulating region (3) a part (1A) of the epitaxial layer (1) that forms the semiconductor body (12), wherein the thickness of the epitaxial layer (1) is between 5 and 15 micrometers;
wherein the second substrate (11) comprises a semiconductor substrate (11), wherein the electrically insulating region (3) is formed by an electrically insulating layer (3), and wherein the electrically insulating layer (3) is deposited or grown on the second substrate (11) before the wafer bonding.

2. Method according to claim 1, wherein the thickness of the epitaxial layer (1) is between 7 and 13 micrometers.

3. Method according to claim 1 or claim 2, wherein the splitting region (2) is formed by a hydrogen implant at a distance below the surface of the epitaxial layer that lies between 0.05 and 2.0 micrometers.

4. Method according to any of the preceding claims, further comprising forming a semiconductor element (T) in the semiconductor body (12).

5. Method according to claim 4, wherein the semiconductor element (T) comprises a field effect transistor.

6. Method according to claim 5, wherein the field effect transistor comprises a high voltage field effect transistor.

## Patentansprüche

1. Verfahren zum Herstellen eines Halbleiterkörpers (12), welcher Silizium und ein Substrat (11) aufweist, wobei eine epitaktische Halbleiterschicht (1), welche Silizium aufweist, oben auf einem ersten Halbleitersubstrat (14) gebildet wird, wobei eine Teilungsregion (2) in der epitaktischen Schicht (1) gebildet wird, wobei ein zweites Substrat (11) mittels Wafer-Bondens mit dem ersten Substrat (14) an der Seite der epitaktischen Schicht (1) befestigt wird, welche mit der Teilungsregion (2) bereitgestellt ist, während eine elektrisch isolierende Region (3) zwischen der epitaktischen Schicht (1) und dem zweiten Substrat (11) eingefügt wird, wobei die dadurch gebildete Struktur an der Position der Teilungsregion (2) geteilt wird, infolgedessen das zweite Substrat (11) das Substrat (11) mit einem Teil (1A) der epitaktischen Schicht (1) oben auf der isolierenden Region (3) bildet, welcher den Halbleiterkörper (12) bildet, wobei die Dicke der epitaktischen Schicht (1) zwischen 5 und 15 Mikrometern ist,
wobei das zweite Substrat (11) ein Halbleitersubstrat (11) aufweist, wobei die elektrisch isolierende Region (3) mittels einer elektrisch isolierenden Schicht (3) gebildet wird, und wobei die elektrisch isolierende Schicht (3) auf dem zweiten Substrat (11) vor dem Wafer-Bonden abgelagert oder gewachsen wird.

2. Verfahren gemäß Anspruch 1, wobei die Dicke der epitaktischen Schicht (1) zwischen 7 und 13 Mikrometern ist.

3. Verfahren gemäß Anspruch 1 oder Anspruch 2, wobei die Teilungsregion (2) mittels einer Wasserstoffimplantierung bei einem Abstand unterhalb der Oberfläche der epitaktischen Schicht gebildet wird, welcher zwischen 0,05 und 2,0 Mikrometern liegt.

4. Verfahren gemäß irgendeinem der vorangehenden Ansprüche, welches ferner ein Bilden eines Halbleiterelements (T) in dem Halbleiterkörper (12) aufweist.

5. Verfahren gemäß Anspruch 4, wobei das Halbleiterelement (T) einen Feldeffekttransistor aufweist.

6. Verfahren gemäß Anspruch 5, wobei der Feldeffekttransistor einen Hochspannungs-Feldeffekttransistor aufweist.

## Revendications

1. Procédé de fabrication d'un corps de semi-conducteur (12) comprenant du silicium et un substrat (11) dans lequel est formée, au-dessus d'un premier substrat de semi-conducteur (14), une couche épitaxiale de semi-conducteur (1) comprenant du silicium, dans lequel une région de séparation (2) est formée dans la couche épitaxiale (1), dans lequel un deuxième substrat (11) est fixé au premier substrat (14) par brasure de tranche du côté de la couche épitaxiale (1) munie de la région de séparation (2), tandis qu'une région électriquement isolante (3) est interposée entre la couche épitaxiale (1) et le deuxième substrat (11), la structure ainsi formée est séparée à l'emplacement de la région de séparation (2), ce qui a pour résultat que le deuxième substrat (11) forme le substrat (11) avec, au-dessus de la région isolante (3), une partie (1A) de la couche épitaxiale (1) qui forme le corps semi-conducteur (12) dans lequel l'épaisseur de la couche épitaxiale (1) est comprise entre 5 et 15 5 microns,
dans lequel le deuxième substrat (11) comprend un substrat semi-conducteur (11), dans lequel est formée la région électriquement isolante (3) à l'aide d'une couche électriquement isolante (3), et dans lequel la couche électriquement isolante (3) est déposée ou obtenue par croissance sur le deuxième substrat (11) avant la brasure de tranche.

2. Procédé selon la revendication 1, dans lequel l'épaisseur de la couche épitaxiale (1) est comprise entre 7 et 13 microns.

3. Procédé selon les revendications 1 ou 2, dans lequel la région de séparation (2) est formée par une implantation d'hydrogène à une distance sous la surface de la couche épitaxiale qui est comprise entre 0,05 et 2,0 microns.

4. Procédé selon l'une quelconque des revendications précédentes, comprenant en outre la formation d'un élément semi-conducteur (T) dans le corps semi-conducteur (12).

5. Procédé selon la revendication 4, dans lequel l'élément semi-conducteur (T) comprend un transistor à effet de champ.

6. Procédé selon la revendication 5, dans lequel le transistor à effet de champ comprend un transistor à effet de champ haute tension.
